# EUROPEAN PATENT APPLICATION

(11) **EP 4 300 588 A1**
(43) Date of publication of application: **03.01.2024**
(21) Application number: 23175335.1
(22) Date of filing: 25.05.2023
(51) Int. Cl.: H01L 29/06, H01L 29/08, H01L 29/24, H01L 29/417, H01L 29/423, H01L 21/34, H01L 29/778

(54) **CONTACT ARCHITECTURE FOR 2D STACKED NANORIBBON TRANSISTOR**

(30) Priority: 30.06.2022 US 202217855639
(71) Applicant: INTEL Corporation, Santa Clara, CA 95054 (US)
(72) Inventor: PENUMATCHA, Ashish Verma, Beaverton, 97003 (US); O'BRIEN, Kevin P., Portland, 97209 (US); MAXEY, Kirby, Hillsboro, 97123 (US); NAYLOR, Carl H., Portland, 97229 (US); DOROW, Chelsey, Portland, 97209 (US); AVCI, Uygar E., Portland, 97225 (US); METZ, Matthew V., Portland, 97229 (US); LEE, Sudarat, Hillsboro, 97124 (US); LIN, Chia-Ching, Portland, 97229 (US); MA, Sean T., Portland, 97221 (US)
(74) Representative: 2SPL Patentanwälte PartG mbB

(57) **Abstract**

Embodiments disclosed herein include transistors and methods of forming transistors. In an embodiment, the transistor comprises a channel with a first end and a second end opposite from the first end, a first spacer around the first end of the channel, a second spacer around the second end of the channel, and a gate stack over the channel, where the gate stack is between the first spacer and the second spacer. In an embodiment, the transistor may further comprise a first extension contacting the first end of the channel; and a second extension contacting the first end of the channel. In an embodiment, the transistor further comprises conductive layers over the first extension and the second extension outside of the first spacer and the second spacer.

## Description

### TECHNICAL FIELD

Embodiments of the disclosure are in the field of semiconductor structures and processing and, in particular, to contact architectures for 2D stacked nanoribbon transistors.

### BACKGROUND

For the past several decades, the scaling of features in integrated circuits has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for ever-more capacity, however, is not without issue. The necessity to optimize the performance of each device becomes increasingly significant.

Variability in conventional and currently known fabrication processes may limit the possibility to further extend them into the 10 nanometer node or sub-10 nanometer node range. Consequently, fabrication of the functional components needed for future technology nodes may require the introduction of new methodologies or the integration of new technologies in current fabrication processes or in place of current fabrication processes.

In the manufacture of integrated circuit devices, multi-gate transistors, such as tri-gate transistors and gate-all-around (GAA) transistors, have become more prevalent as device dimensions continue to scale down. Tri-gate transistors and GAA transistors are generally fabricated on either bulk silicon substrates or silicon-on-insulator substrates. In some instances, bulk silicon substrates are preferred due to their lower cost and compatibility with the existing high-yielding bulk silicon substrate infrastructure.

Scaling multi-gate transistors has not been without consequence, however. As the dimensions of these fundamental building blocks of microelectronic circuitry are reduced and as the sheer number of fundamental building blocks fabricated in a given region is increased, the constraints on the semiconductor processes used to fabricate these building blocks have become overwhelming.

### BRIEF DESCRIPTION OF THE DRAWINGS

Figure 1A is a cross-sectional illustration of a transistor device with a gate-all-around (GAA) structure with source/drain regions provided on ends of the semiconductor channels.
Figure 1B is a cross-sectional illustration of a transistor device with a GAA structure with a contact metal directly contacting the ends of the semiconductor channels.
Figure 2A is a cross-sectional illustration of a transistor device with a GAA structure that includes conductive extensions at the ends of the semiconductor channels, in accordance with an embodiment.
Figure 2B is a cross-sectional illustration of a transistor device with a GAA structure that includes conductive extensions at the ends of the semiconductor channels that have merged together, in accordance with an embodiment.
Figure 2C is a cross-sectional illustration of a transistor device with a GAA structure that includes conductive extensions at the ends of the semiconductor channels that include a surface treatment, in accordance with an embodiment.
Figure 3A is a perspective view illustration of a transistor device with a gate stack over the semiconductor channels, where the gate stack is between spacers, in accordance with an embodiment.
Figure 3B is a perspective view illustration of the transistor device after extensions are grown on the ends of the semiconductor channels that pass through the spacers, in accordance with an embodiment.
Figure 3C is a perspective view illustration of the transistor device after a contact metal is disposed around the extensions outside of the spacers, in accordance with an embodiment.
Figure 4 illustrates a computing device in accordance with one implementation of an embodiment of the disclosure.
Figure 5 is an interposer implementing one or more embodiments of the disclosure.

### DESCRIPTION OF THE EMBODIMENTS

Embodiments described herein comprise contact architectures for 2D stacked nanoribbon transistors. In the following description, numerous specific details are set forth, such as specific integration and material regimes, in order to provide a thorough understanding of embodiments of the present disclosure. It will be apparent to one skilled in the art that embodiments of the present disclosure may be practiced without these specific details. In other instances, well-known features, such as integrated circuit design layouts, are not described in detail in order to not unnecessarily obscure embodiments of the present disclosure. Furthermore, it is to be appreciated that the various embodiments shown in the Figures are illustrative representations and are not necessarily drawn to scale.

Certain terminology may also be used in the following description for the purpose of reference only, and thus are not intended to be limiting. For example, terms such as "upper", "lower", "above", "below," "bottom," and "top" refer to directions in the drawings to which reference is made. Terms such as "front", "back", "rear", and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

Transition metal dichalcogenides (TMDs) enable aggressive scaling of channel length below 10nm. At these channel lengths, the contact resistance is a significant portion of the overall on-resistance. One approach to fabricating TMD transistor devices is to grow a metallic phase of the TMD material outside of the spacers. However, metallic phases of TMD materials have higher resistances that traditional bulk contact metal. As such, the number of channels that can be stacked is limited by a high IR drop in the source/drain region. In an alternative architecture, a bulk contact metal is deposited outside of the spacers. While the resistance of such a structure is improved, manufacturing functional devices is made more difficult. This is because the exposed edge of the TMD channel is narrow (e.g., 1nm or less), and it is difficult to make contact to the TMD channel. That is, opens or voids between the bulk contact metal and the TMD channel may lead to underperforming transistor architectures.

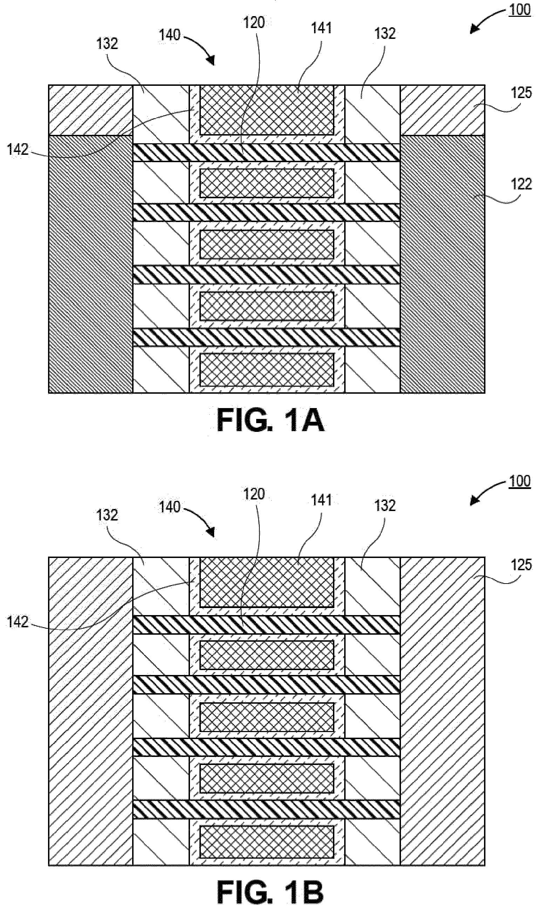

Referring now to Figure 1A, a cross-sectional illustration of a transistor device 100 is shown. The transistor device 100 may include a stack of semiconductor channels 120. The channels 120 may be a TMD channel material. The thickness of the channels 120 may be approximately 1nm or less. The channels 120 may have any form factor, such as a nanoribbon form factor or a nanowire form factor. A gate stack 140 may be provided around the channels 120. For example, the gate stack 140 may include a gate dielectric 142 and a gate metal 141. The gate metal 141 may comprise a workfunction metal and a fill metal in some instances. The gate stack 140 may be provided around the channels 120 between spacers 132. The ends of the channels 120 may pass through the spacers 132.

As shown, a source/drain region 122 may be provided outside of the spacers 132. The source/drain regions 122 may also be a TMD material. For example, the source/drain regions 122 may be a metallic phase of the TMD material used for the channels 120. The source/drain regions 122 may be grown with an epitaxial growth process. While the epitaxial growth process enables good connection between the source/drain regions 122 and the channels 120, the resistance of the source/drain regions 122 is relatively high. Generally, the resistance is greater than the resistance of a bulk contact metal 125, such as tungsten or the like. Accordingly, as noted above, there is a high IR-drop through the height of the source/drain regions 122. This negatively impacts the functionality of the channels 120 towards the bottom of the stack. Therefore, the number of channels 120 that can be stacked in the transistor 100 is limited. This negatively impacts scalability of the transistor 100. Additionally, not all TMD materials have an easy to grow metallic counterpart. This limits the material classes used to form the transistor 100.

Referring now to Figure 1B, a cross-sectional illustration of a transistor device 100 is shown in accordance with an alternative architecture. The transistor device 100 may include a stack of semiconductor channels 120. The channels 120 may be a TMD channel material. The thickness of the channels 120 may be approximately 1nm or less. The channels 120 may have any form factor, such as a nanoribbon form factor or a nanowire form factor. A gate stack 140 may be provided around the channels 120. For example, the gate stack 140 may include a gate dielectric 142 and a gate metal 141. The gate metal 141 may comprise a workfunction metal and a fill metal in some instances. The gate stack 140 may be provided around the channels 120 between spacers 132. The ends of the channels 120 may pass through the spacers 132.

Instead of having a metallic phase of the TMD material, the source/drain regions include a bulk contact metal 125. The use of a bulk contact metal 125 reduces the IR drop through the thickness of the source/drain region. This theoretically will enable the stacking of more channels 120 than the architecture shown in Figure 1A. However, as noted above, there is a significant drawback to such an architecture. Mainly, the contact between the channels 120 and the bulk contact metal 125 is poor. Limitations in etching and deposition processes may result in opens or voids between the ends of the channels 120 and the bulk contact metal 125. This is particularly problematic when the thickness of the channels 120 is reduced below 1nm. Due to the presence of opens or voids, the overall performance of the transistor 100 is diminished.

Accordingly, embodiments disclosed herein include transistor architectures that allow for both a reduced IR drop and improved electrical coupling at the edge of the semiconductor channels. This is done by forming extensions at the edge of the semiconductor channels. The extensions may comprise a metallic phase of the TMD material. Instead of growing the metallic phase of the TMD material to fill the entire source/drain region, small extensions are grown at the outer edges of the semiconductor channels. The remainder of the source/drain region can then be filled with a bulk contact metal that has a lower resistance. The extensions also expand the contact surface area, compared to edges of the semiconductor channels. As such, there is more surface area in order to provide improved electrical coupling between the bulk contact metal and the channel. This mitigates or eliminates the formation of opens or voids and results in an improved transistor performance.

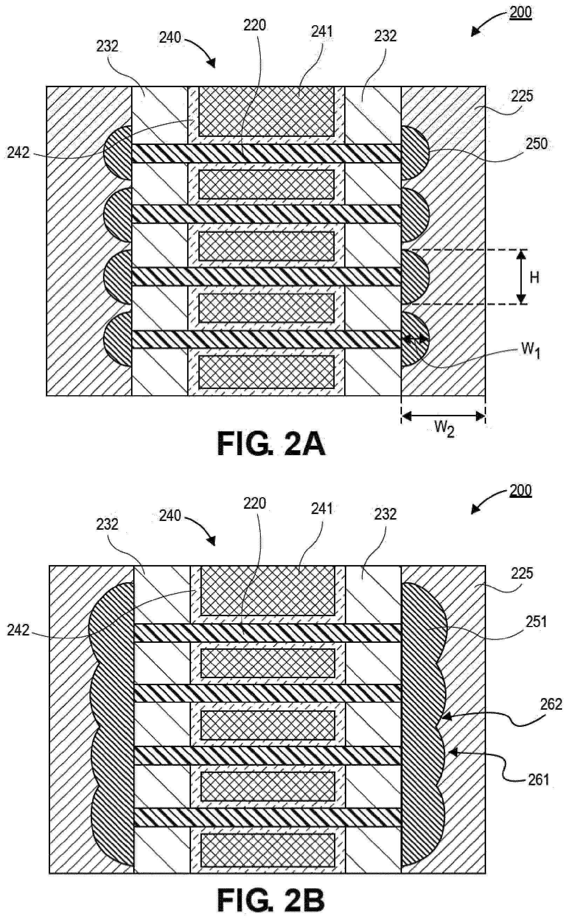

Referring now to Figure 2A, a cross-sectional illustration of a transistor device 200 is shown, in accordance with an embodiment. In an embodiment, the transistor device 200 is a non-planar transistor device. More particularly, the transistor device 200 may be a GAA device. In an embodiment, the transistor device 200 comprises a stack of semiconductor channels 220. For example, four channels 220 are shown in Figure 2A. Though, it is to be appreciated that any number of channels 220 (e.g., one or more) may be included in the transistor device 200.

In a particular embodiment, the semiconductor channels 220 may be a TMD semiconductor material. TMD materials typically take the form of MX₂, where M is transition metal atom (e.g., Mo, W, etc.), and X is a chalcogen atom (e.g., S, Se, or Te). Typically, a layer of M atoms are sandwiched between layers of chalcogen atoms. TMD materials may generally be considered a 2D material. Other 2D semiconductor materials may also be used in some embodiments disclosed herein. The TMD semiconductor material may be a single layer (i.e., a layer of the M atom sandwiched between two X atom layers) or multiple layers thick. The channels 220 may have any form factor. For example, the channels 220 may include nanoribbon channels 220 or nanowire channels 220. A nanoribbon channel refers to a structure that has one confined dimension (e.g., a small thickness compared to a length and a width of the channel), and a nanowire channel refers to a structure that has two confined dimensions (e.g., a small thickness and a small width, compared to a length of the channel). In a particular embodiment, the confined dimension (or dimensions) may have values of 5nm or smaller, or 1nm or smaller. The use of TMD semiconductor materials allows for aggressive scaling of the transistor device 200. For example, channel lengths may be approximately 10nm or smaller.

In an embodiment, the channels 220 may pass through a pair of spacers 232. The ends of the channels 220 may be substantially coplanar with the outer surfaces of the spacers 232. In an embodiment, the spacers 232 may be any suitable spacer material. In one instance the spacers 232 may comprise silicon, oxygen, and carbon (e.g., SiOC). In other embodiments, the spacers 232 may be a material chosen to promote growth of the extensions 250. For example, the spacers 232 may comprise aluminum and oxygen (e.g., a-Al₂O₃).

In an embodiment, a gate stack 240 may be provided around the channels 220. The gate stack 240 may be positioned between the spacers 232. In an embodiment, the gate stack 240 may include a gate dielectric 242 and a gate metal 241. The gate dielectric 242 may be, for example, any suitable oxide such as silicon dioxide or high-k gate dielectric materials. Examples of high-k gate dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric 242 to improve its quality when a high-k material is used.

In an embodiment, the gate metal 241 may include a workfunction metal and a fill metal. When the workfunction metal will serve as an N-type workfunction metal, the gate metal 241 preferably has a workfunction that is between about 3.9 eV and about 4.2 eV. N-type materials that may be used to form the gate metal 241 include, but are not limited to, hafnium, zirconium, titanium, tantalum, aluminum, and metal carbides that include these elements, i.e., titanium carbide, zirconium carbide, tantalum carbide, hafnium carbide and aluminum carbide. When the workfunction metal will serve as a P-type workfunction metal, the gate metal 241 preferably has a workfunction that is between about 4.9 eV and about 5.2 eV. P-type materials that may be used to form the gate metal 241 include, but are not limited to, ruthenium, palladium, platinum, cobalt, nickel, and conductive metal oxides, e.g., ruthenium oxide.

In an embodiment, the transistor 200 may further comprise extensions 250 at the ends of the channels 232. For example, the extensions 250 may be in direct contact with the end surfaces of the channels 220 and the outside surfaces of the spacers 232. The extensions 250 may be a metal phase of the TMD used to form the channels 220. The extensions 250 may be grown over the ends of the channels 220 with an epitaxial growth process. As such, the connection between the extensions 250 and the channels 220 will be excellent without any voids or openings.

In an embodiment, the extensions 250 may have a semicircular cross-section. The flat surface of the extensions 250 may contact the channels 220 and the outside surfaces of the spacers 232, and the rounded surface of the extensions 250 may face away from the channels 220. In an embodiment, a height H of the extensions 250 may be approximately 10nm or smaller. In a particular embodiment, the height H of the extensions 250 may be between approximately 5nm and approximately 10nm. As used herein, "approximately" may refer to a range of values within ten percent of the stated value. For example, approximately 10nm may refer to a range between 9nm and 11nm. In an embodiment, a width Wi of the extensions 250 may be up to half of the width W₂ of the bulk contact metal 225. For example, the width Wi may be up to approximately 5nm, and the width W₂ may be up to approximately 10nm.

In the illustrated embodiment, each of the extensions 250 may be discrete from each other. That is, the spacing between the channels 220 may be large enough in order to grow the extensions to a desired size without the extensions 250 merging together. Keeping the extensions 250 separate from each other increases the total surface area available to be contacted with the bulk contact metal 225. For example, a portion of the bulk contact metal 225 may be provided between neighboring extensions 250. The portion of the bulk contact metal 225 between neighboring extensions 250 may directly contact an outer surface of the spacer 232. As such, the contact resistance can be reduced, and performance may be improved.

In an embodiment, the bulk contact metal 225 may be any suitable contact metal used in semiconductor processing environments. For example, the bulk contact metal 225 may comprise tungsten, other metals, or other alloys. The bulk contact metal 225 may conform to the shape of the extensions 250. In some instances, the bulk contact metal 225 may be in direct contact with the spacers 232 and the extensions 250. However, due to the presence of the extensions 250, the bulk contact metal 225 may not directly contact the channels 220.

Referring now to Figure 2B, a cross-sectional illustration of a transistor device 200 is shown, in accordance with an additional embodiment. In an embodiment, the transistor device 200 comprises a stack of semiconductor channels 220. For example, four channels 220 are shown in Figure 2B. However, it is to be appreciated that any number of channels 220 may be included in the transistor device 200. In an embodiment, the channels 220 may comprise a semiconductive TMD material. In an embodiment, spacers 232 may be provided at the ends of the channels 220. Additionally, a gate stack 240 may be provided around the channels 220 between the spacers 232. The gate stack 240 may comprise a gate metal 241 and a gate dielectric 242. The materials for the spacers 232, the gate metal 241, and the gate dielectric 242 may be substantially similar to materials for the similarly named structures described above with respect to Figure 2A.

In an embodiment, the transistor 200 may further comprise merged extensions 251 on opposite ends of the channels 220. The merged extensions 251 may include a metallic phase of the TMD material used to form the channels 220. In an embodiment, the merged extensions 251 may be epitaxially grown from the edges of the channels 220. As such, the growth starts with extensions on individual ones of the channels 220. As the growth continues, the discrete extensions begin to merge together in order to form a single merged extension 251 on each side of the channels. The merged extension 251 may have a substantially planar surface facing the spacer 232 and the channels 220. The opposite surface of the merged extensions 251 may be non-planar. For example, the non-planar surface may be referred to as a scalloped surface in some embodiments. In a particular embodiment, the non-planar surface may have ridges 261 that are substantially aligned with (e.g., centered on) the channels 220 and valleys 262 that are provided between the channels 220.

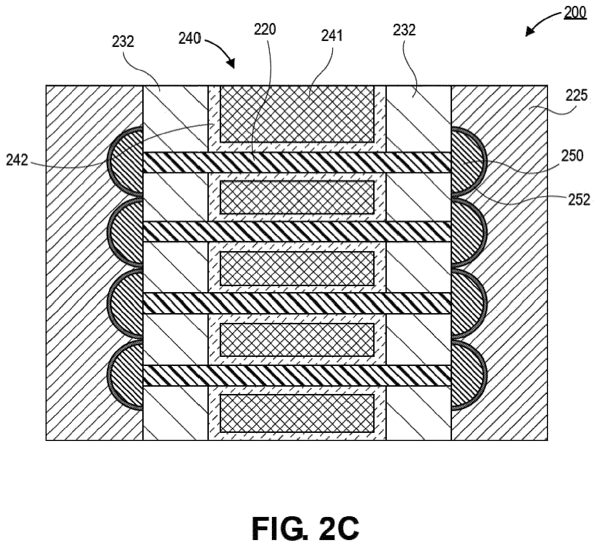

Referring now to Figure 2C, a cross-sectional illustration of a transistor device 200 is shown, in accordance with an additional embodiment. In an embodiment, the transistor device 200 comprises a stack of semiconductor channels 220. For example, four channels 220 are shown in Figure 2C. However, it is to be appreciated that any number of channels 220 may be included in the transistor device 200. In an embodiment, the channels 220 may comprise a semiconductive TMD material. In an embodiment, spacers 232 may be provided at the ends of the channels 220. Additionally, a gate stack 240 may be provided around the channels 220 between the spacers 232. The gate stack 240 may comprise a gate metal 241 and a gate dielectric 242. The materials for the spacers 232, the gate metal 241, and the gate dielectric 242 may be substantially similar to materials for the similarly named structures described above with respect to Figure 2A.

In an embodiment, extensions 250 are provided at the ends of each of the channels 220. The extensions 250 may comprise a metallic phase of the TMD material used for the channels 220. In the illustrated embodiment, the extensions 250 are distinct features. That is, the extensions 250 are not merged together in some embodiments. In an embodiment, the extensions 250 may include a surface treatment 252. The surface treatment 252 may be a treatment that decreases the contact resistance between the bulk contact metal 225 and the extensions 250. In practice, the surface treatment 252 may be similar to the use of a silicide in silicon based devices. In a particular embodiment, the surface treatment 252 may include a nitric oxide treatment of the extensions 250. For example, the surface treatment 252 may comprise nitrogen. The surface treatment 252 may be on surfaces of the extension 250 that are between the extension 250 and the bulk contact metal 225. That is, the surfaces of the extension 250 that face the spacers 232 and the channels 220 may not have the surface treatment 252.

While non-merged extensions 250 are shown in Figure 2C, it is to be appreciated that similar surface treatments 252 may also be applied in a merged architecture, such as the example shown in Figure 2B. In such an embodiment, the surface treatment 252 may be a continuous layer that is formed along the surfaces of the merged extensions 251 that interface with the bulk contact metal 225.

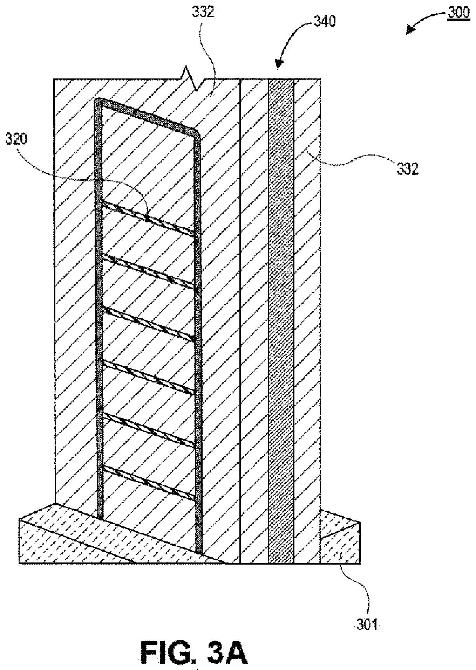

Referring now to Figures 3A-3C, a series of illustrations depicting a process for forming a transistor with metallic phase TMD extensions is shown, in accordance with an embodiment.

Referring now to Figure 3A, a perspective view illustration of a transistor device 300 at a stage of manufacture is shown, in accordance with an embodiment. As shown, a stack of semiconductor channels 320 may pass through a spacer 332. The channels 320 may also pass through a gate stack 340 and the spacer 332 on the opposite side of Figure 3A. The gate stack 340 may be a dummy gate stack, or the final gate stack. In the case of a dummy gate stack, the gate stack 340 may be replaced with the gate dielectric and gate metal is a subsequent processing operation, as is known in the art of semiconductor fabrication. In the illustrated embodiment, six channels 320 are shown. However, it is to be appreciated that any number of channels 320 may be used in the transistor device 300.

In the illustrated embodiment, the channels 320 are shown as being nanoribbon structures. However, in other embodiments, the channels 320 may be nanowire structures. The channels 320 may include any suitable semiconductor TMD material. The use of TMD materials allows for aggressive scaling of the transistor device 300. For example, channel lengths of the transistor device may be approximately 10nm or smaller.

In an embodiment, the transistor device 300 may be fabricated over a substrate 301. In some embodiments, the substrate 301 may include a semiconductor substrate, such as a silicon substrate. The semiconductor substrate 301 often includes a wafer or other piece of silicon or another semiconductor material. Suitable semiconductor substrates 301 include, but are not limited to, single crystal silicon, polycrystalline silicon and silicon on insulator (SOI), as well as similar substrates formed of other semiconductor materials, such as substrates including germanium, carbon, or group III-V materials.

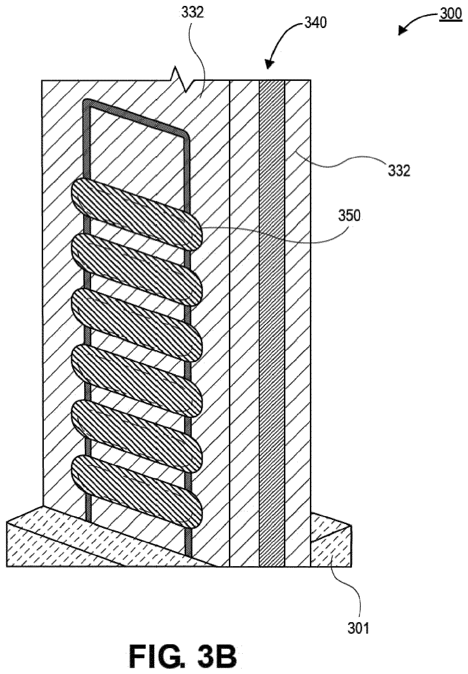

Referring now to Figure 3B, a perspective view illustration of the transistor device 300 after extensions 350 are formed over the exposed ends of the channels 320 is shown, in accordance with an embodiment. In an embodiment, the extensions 350 may be a metal phase of the TMD material used for the channels 320. The extensions 350 may be grown with an epitaxial process. For example, the extensions 350 may be grown with an atomic layer deposition (ALD) process or a chemical vapor deposition (CVD) process. The extensions 350 may have rounded surfaces that face away from the spacer 332. In an embodiment, the growth of the extensions 350 is halted before the individual extensions 350 begin to merge together. However, in other embodiments, the extensions 350 may be grown until the extensions 350 begin to merge together (e.g., similar to the embodiment shown in Figure 2B). In some embodiments, a surface treatment may be applied to the extensions 350. For example, a nitric oxide treatment may be applied to PMOS type contacts. In such an embodiment, the extensions 350 may also comprise nitrogen.

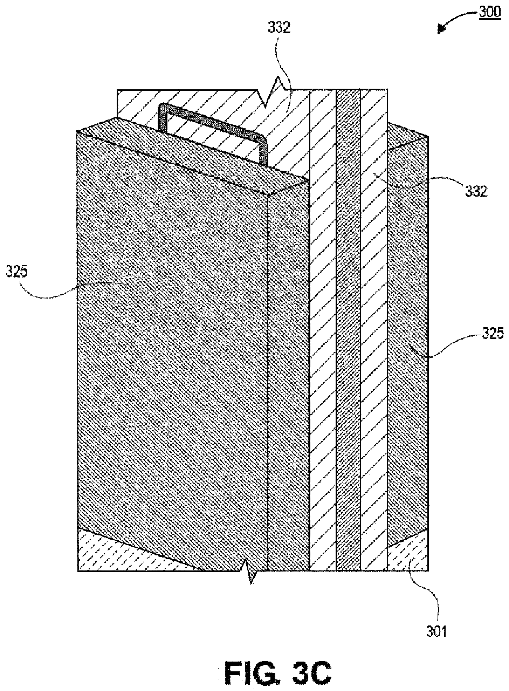

Referring now to Figure 3C, a perspective view illustration of the transistor device 300 after the bulk contact metal 325 is formed is shown, in accordance with an embodiment. As shown, the bulk contact metal 325 may surround the extensions 350 outside of the spacers 332. The bulk contact metal 325 may be deposited with any suitable deposition process. For example, a CVD process may be used in some embodiments. Due to the decreased resistance compared to the extensions 350, the bulk contact metal 325 reduces the IR drop and allows for an increased number of channels 320 to be stacked in the transistor device 300. Additionally, the increased surface area of the extensions 350 allows for improved electrical coupling to the channels 320.

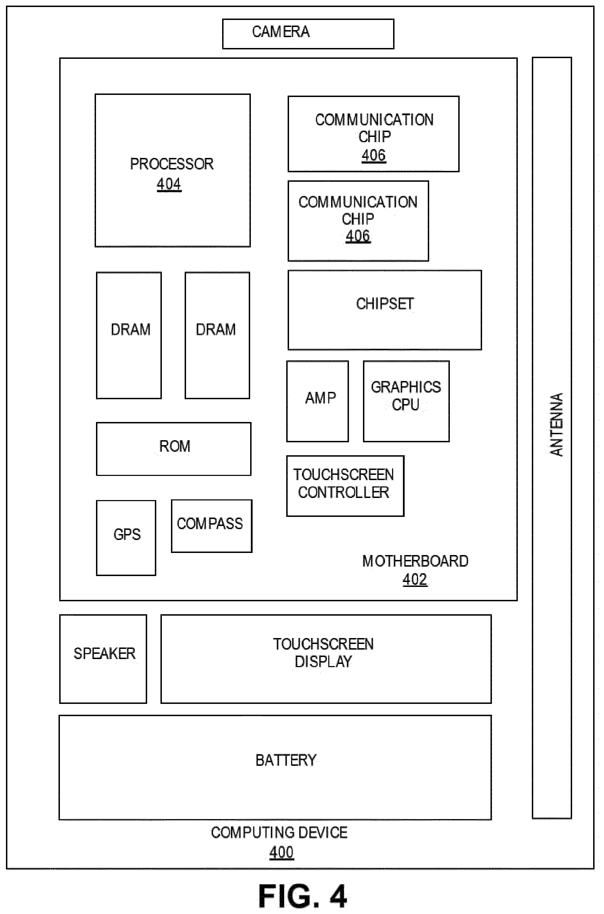

Figure 4 illustrates a computing device 400 in accordance with one implementation of an embodiment of the disclosure. The computing device 400 houses a board 402. The board 402 may include a number of components, including but not limited to a processor 404 and at least one communication chip 406. The processor 404 is physically and electrically coupled to the board 402. In some implementations the at least one communication chip 406 is also physically and electrically coupled to the board 402. In further implementations, the communication chip 406 is part of the processor 404.

Depending on its applications, computing device 400 may include other components that may or may not be physically and electrically coupled to the board 402. These other components include, but are not limited to, volatile memory (e.g., DRAM), nonvolatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 406 enables wireless communications for the transfer of data to and from the computing device 400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 406 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 400 may include a plurality of communication chips 406. For instance, a first communication chip 406 may be dedicated to shorter range wireless communications such as Wi-Fi and Bluetooth and a second communication chip 406 may be dedicated to longer range wireless communications such as GPS, EDGE, GPRS, CDMA, WiMAX, LTE, Ev-DO, and others.

The processor 404 of the computing device 400 includes an integrated circuit die packaged within the processor 404. In an embodiment, the integrated circuit die of the processor may comprise a transistor device with a GAA structure that includes extensions out from a TMD channel, as described herein. The term "processor" may refer to any device or portion of a device that processes electronic data from registers and/or memory to transform that electronic data into other electronic data that may be stored in registers and/or memory.

The communication chip 406 also includes an integrated circuit die packaged within the communication chip 406. In an embodiment, the integrated circuit die of the communication chip may comprise a transistor device with a GAA structure that includes extensions out from a TMD channel, as described herein.

In further implementations, another component housed within the computing device 400 may comprise a transistor device with a GAA structure that includes extensions out from a TMD channel, as described herein.

In various implementations, the computing device 400 may be a laptop, a netbook, a notebook, an ultrabook, a smartphone, a tablet, a personal digital assistant (PDA), an ultra mobile PC, a mobile phone, a desktop computer, a server, a printer, a scanner, a monitor, a set-top box, an entertainment control unit, a digital camera, a portable music player, or a digital video recorder. In further implementations, the computing device 400 may be any other electronic device that processes data.

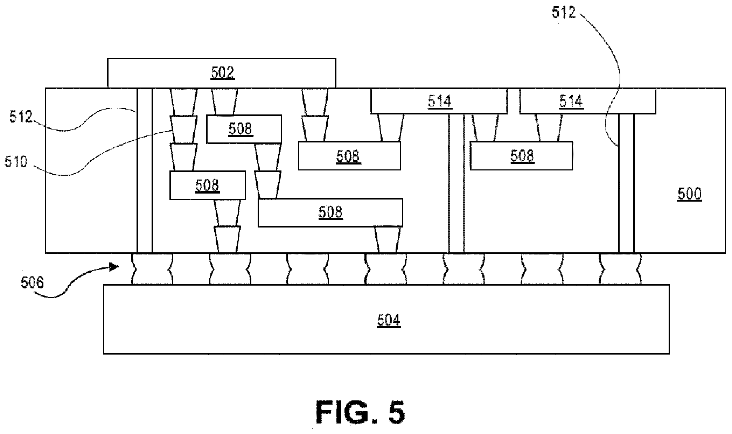

Figure 5 illustrates an interposer 500 that includes one or more embodiments of the disclosure. The interposer 500 is an intervening substrate used to bridge a first substrate 502 to a second substrate 504. The first substrate 502 may be, for instance, an integrated circuit die. The second substrate 504 may be, for instance, a memory module, a computer motherboard, or another integrated circuit die. In an embodiment, one of both of the first substrate 502 and the second substrate 504 may comprise a transistor device with a GAA structure that includes extensions out from a TMD channel, in accordance with embodiments described herein. Generally, the purpose of an interposer 500 is to spread a connection to a wider pitch or to reroute a connection to a different connection. For example, an interposer 500 may couple an integrated circuit die to a ball grid array (BGA) 506 that can subsequently be coupled to the second substrate 504. In some embodiments, the first and second substrates 502/504 are attached to opposing sides of the interposer 500. In other embodiments, the first and second substrates 502/504 are attached to the same side of the interposer 500. And in further embodiments, three or more substrates are interconnected by way of the interposer 500.

The interposer 500 may be formed of an epoxy resin, a fiberglass-reinforced epoxy resin, a ceramic material, or a polymer material such as polyimide. In further implementations, the interposer 500 may be formed of alternate rigid or flexible materials that may include the same materials described above for use in a semiconductor substrate, such as silicon, germanium, and other group III-V and group IV materials.

The interposer 500 may include metal interconnects 508 and vias 510, including but not limited to through-silicon vias (TSVs) 512. The interposer 500 may further include embedded devices 514, including both passive and active devices. Such devices include, but are not limited to, capacitors, decoupling capacitors, resistors, inductors, fuses, diodes, transformers, sensors, and electrostatic discharge (ESD) devices. More complex devices such as radio-frequency (RF) devices, power amplifiers, power management devices, antennas, arrays, sensors, and MEMS devices may also be formed on the interposer 500. In accordance with embodiments of the disclosure, apparatuses or processes disclosed herein may be used in the fabrication of interposer 500.

Thus, embodiments of the present disclosure may comprise a transistor device with a GAA structure that includes extensions out from a TMD channel.

The above description of illustrated implementations of embodiments of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

These modifications may be made to the disclosure in light of the above detailed description. The terms used in the following claims should not be construed to limit the disclosure to the specific implementations disclosed in the specification and the claims. Rather, the scope of the disclosure is to be determined entirely by the following claims, which are to be construed in accordance with established doctrines of claim interpretation.

Example 1: a transistor, comprising: a channel with a first end and a second end opposite from the first end; a first spacer around the first end of the channel; a second spacer around the second end of the channel; a gate stack over the channel, wherein the gate stack is between the first spacer and the second spacer; a first extension contacting the first end of the channel; a second extension contacting the first end of the channel; and conductive layers over the first extension and the second extension outside of the first spacer and the second spacer.

Example 2: the transistor of Example 1, wherein the channel is a nanoribbon channel.

Example 3: the transistor of Example 1, wherein the channel is a nanowire channel.

Example 4: the transistor of Example 1 or Example 2, wherein the channel is a transition metal dichalcogenide (TMD).

Example 5: the transistor of Example 4, wherein the first extension and the second extension are metallic phase TMDs.

Example 6: the transistor of Examples 1-5, wherein the first extension and the second extension have semicircular cross-sections.

Example 7: the transistor of Example 6, wherein portions of the first extension and the second extension contact the first spacer or the second spacer.

Example 8: the transistor of Examples 1-7, wherein a height of the first extension and the second extension is between approximately 5nm and approximately 10nm.

Example 9: the transistor of Examples 1-8, wherein a width of the first extension and the second extension is up to approximately half of a width of the conductive layers.

Example 10: the transistor of Example 9, wherein the width of the first extension and the second extension is approximately 5nm or less.

Example 11: the transistor of Examples 1-10, further comprising: a surface treatment layer over the first extension and the second extension.

Example 12: the transistor of Example 11, wherein the surface treatment layer comprises nitrogen.

Example 13: the transistor of Examples 1-12, wherein the first spacer and the second spacer comprise aluminum and oxygen.

Example 14: the transistor of Examples 1-13, wherein a channel length of the channel is approximately 10nm or less.

Example 15: a transistor device, comprising: a stack of semiconductor channels; a gate stack over and around the stack of semiconductor channels; spacers at opposite ends of the gate stack; and extensions at ends of individual ones of the semiconductor channels.

Example 16: the transistor device of Example 15, wherein the extensions merge together to form a single body.

Example 17: the transistor device of Example 15 or Example 16, wherein the extensions directly contact semiconductor channels and the spacers.

Example 18: the transistor device of Examples 15-17, wherein the extensions have a surface treatment layer comprising nitrogen.

Example 19: the transistor device of Examples 15-18, wherein the stack of semiconductor channels comprise transition metal dichalcogenide (TMD) materials.

Example 20: the transistor device of Example 19, wherein the extensions comprise metallic phase TMD materials.

Example 21: the transistor device of Examples 15-20, further comprising: conductive layers around the extensions.

Example 22: the transistor device of Example 21, wherein a width of the conductive layers is approximately twice a width of the extensions or greater.

Example 23: an electronic system, comprising: a board; a package substrate coupled to the board; and a die coupled to the package substrate, wherein the die comprises: a gate-all-around (GAA) transistor device with a semiconductor channel that is surrounded by a gate stack that is between a pair of spacers, wherein extensions are provided at ends of the semiconductor channel outside of the spacers, and wherein the semiconductor channel comprises a transition metal dichalcogenide (TMD), wherein the TMD takes the form of MX₂, wherein M is transition metal atom including molybdenum or tungsten, and X is a chalcogen atom including sulfur, selenium, or tellurium.

Example 24: the electronic system of Example 23, wherein the extensions comprise a metallic phase TMD.

Example 25: the electronic system of Example 23 or Example 24, wherein the extensions contact the semiconductor channel and the spacers, and wherein a conductive layer is provided around the extensions.

## Claims

1. A transistor, comprising:
a channel with a first end and a second end opposite from the first end;
a first spacer around the first end of the channel;
a second spacer around the second end of the channel;
a gate stack over the channel, wherein the gate stack is between the first spacer and the second spacer;
a first extension contacting the first end of the channel;
a second extension contacting the first end of the channel; and
conductive layers over the first extension and the second extension outside of the first spacer and the second spacer.

2. The transistor of claim 1, wherein the channel is a nanoribbon channel.

3. The transistor of claim 1, wherein the channel is a nanowire channel.

4. The transistor of claim 1, 2 or 3, wherein the channel is a transition metal dichalcogenide (TMD).

5. The transistor of claim 4, wherein the first extension and the second extension are metallic phase TMDs.

6. The transistor of claim 1, 2, 3, 4 or 5, wherein the first extension and the second extension have semicircular cross-sections.

7. The transistor of claim 6, wherein portions of the first extension and the second extension contact the first spacer or the second spacer.

8. The transistor of claim 1, 2, 3, 4, 5, 6 or 7, wherein a height of the first extension and the second extension is between approximately 5nm and approximately 10nm.

9. The transistor of claim 1, 2, 3, 4, 5, 6, 7 or 8, wherein a width of the first extension and the second extension is up to approximately half of a width of the conductive layers.

10. The transistor of claim 9, wherein the width of the first extension and the second extension is approximately 5nm or less.

11. The transistor of claim 1, 2, 3, 4, 5, 6, 7, 8, 9 or 10, further comprising:
a surface treatment layer over the first extension and the second extension.

12. A method of fabricating a transistor, the method comprising:
forming a channel with a first end and a second end opposite from the first end;
forming a first spacer around the first end of the channel;
forming a second spacer around the second end of the channel;
forming a gate stack over the channel, wherein the gate stack is between the first spacer and the second spacer;
forming a first extension contacting the first end of the channel;
forming a second extension contacting the first end of the channel; and
forming conductive layers over the first extension and the second extension outside of the first spacer and the second spacer.

13. The method of claim 12, wherein the channel is a nanoribbon channel.

14. The method of claim 12, wherein the channel is a nanowire channel.

15. The method of claim 12, 13 or 14, wherein the channel is a transition metal dichalcogenide (TMD).
